Europäisches Patentamt

European Patent Office

Office européen des brevets

(19)

(11) Veröffentlichungsnummer: **0 245 823**

**A2**

(12) **EUROPÄISCHE PATENTANMELDUNG**

(21) Anmeldenummer: **87106819.3**

(22) Anmeldetag: **11.05.87**

(51) Int. Cl.⁴: **H03J 7/18**

(30) Priorität: **16.05.86 DE 3616592**

(43) Veröffentlichungstag der Anmeldung:
**19.11.87 Patentblatt 87/47**

(84) Benannte Vertragsstaaten:
**AT CH DE LI**

(71) Anmelder: **Blaupunkt-Werke GmbH**
**Robert-Bosch-Strasse 200**
**D-3200 Hildesheim(DE)**

(72) Erfinder: **Liman, Helmut**
**Meerbrink 19**
**D-3201 Klein Escherde(DE)**

(74) Vertreter: **Eilers, Norbert, Dipl.-Phys.**
**Blaupunkt-Werke GmbH**
**Robert-Bosch-Strasse 200**
**D-3200 Hildesheim(DE)**

(54) **Verfahren und Schaltungsanordnung zur Abstimmung eines Autoradios.**

(57) Bei einem Verfahren zur Abstimmung eines Autoradios auf Verkehrsfunksender, bei welchem automatisch bei Unterschreiten eines vorgegebenen Pegels eines empfangenen Senders oder manuell ein Suchlauf gestartet wird, wird der Suchlauf automatisch beim Empfang eines Senders mit ausreichendem Pegel angehalten, wenn der Sender mit ausreichendem Pegel eine gleiche Bereichskennung wie der zuvor empfangene Sender aussendet. Dabei kann vorgesehen sein, daß nach einem manuellen Start der Suchlauf auch bei einem Sender mit ausreichendem Pegel, der eine andere Bereichskennung als der zuvor empfangene Sender aussendet, angehalten wird.

EP 0 245 823 A2

## Verfahren und Schaltungsanordnung zur Abstimmung eines Autoradios

Die Erfindung geht aus von einem Verfahren nach der Gattung des Hauptanspruchs.

Zur Übermittlung von Verkehrsinformationen an Autofahrer sind Verkehrsfunksysteme bekannt, bei welchen zusätzlich zu dem Programm Signale zur Kennzeichnung, daß der betreffende Sender Verkehrsinformationen ausstrahlt, daß eine Sendung von Verkehrsinformationen zur Zeit erfolgt und daß die Verkehrsinformationen für ein bestimmtes geographisches Gebiet gesendet werden. Letzteres wird Bereichskennung genannt.

Es ist ferner bei Geräten mit Sendersuchlauf bekannt, die Bereichskennung dahingehend auszuwerten, daß angezeigt wird, ob ein Sender eine vorwählbare Bereichskennung sendet (passive Bereichskennung). Die Bereichskennung kann auch derart ausgewertet werden, daß der Sendersuchlauf nur bei Sendern, die eine vorwählbare Bereichskennung senden, angehalten wird (aktive Bereichskennung).

Diese bekannten Verfahren haben den Nachteil, daß der Autofahrer die Einstellung des Bereichs vorzunehmen und gegebenenfalls die Bereichskennungsanzeige zu beobachten hat, was seine Aufmerksamkeit möglicherweise vom Verkehrsgeschehen ablenkt.

Das erfindungsgemäße Verfahren mit den kennzeichnenden Merkmalen des Hauptanspruchs hat demgegenüber den Vorteil, daß bei Unterschreiten eines vorgegebenen Pegels automatisch ein anderer Sender mit der gleichen Bereichskennung gesucht wird, ohne daß der Autofahrer vorher den betreffenden Bereich gewählt hat.

Durch die in den Unteransprüchen aufgeführten Maßnahmen sind vorteilhafte Weiterbildungen und Verbesserungen der im Hauptanspruch angegebenen Erfindung sowie vorteilhafte Schaltungen zur Durchführung des erfindungsgemäßen Verfahrens möglich.

Besonders vorteilhaft ist, wenn gemäß einer Weiterbildung der Erfindung der Suchlauf bei einem beliebigen Sender mit ausreichendem Pegel vorläufig angehalten wird, ein Vergleich der Bereichskennungen des zuvor empfangenen Senders und des gerade empfangenen Senders erfolgt und der Suchlauf wieder gestartet wird, wenn das Ergebnis des Vergleichs Ungleichheit ist.

Eine andere Weiterbildung der Erfindung sieht vor, daß nach einem manuellen Start der Suchlauf auch bei einem Sender, der einen ausreichenden Pegel aufweist, jedoch eine andere Bereichskennung als der zuvor empfangene Sender aussendet, angehalten wird.

Diese Weiterbildung berücksichtigt in vorteilhafter Weise, daß bei einem manuellen Start im Gegensatz zu einem Start in Folge eines zu geringen Pegels vom Autofahrer der Empfang eines anderen Programms gewünscht wird.

Andere Weiterbildungen sehen Maßnahmen für den Fall vor, daß das Fahrzeug einen Bereich verläßt. Diese Maßnahmen können darin bestehen, daß der Suchlauf bei einem Sender mit ausreichendem Pegel und beliebiger Bereichskennung angehalten wird, wenn der Suchlauf mindestens einmal den gesamten Frequenzbereich durchlaufen hat.

Es kann jedoch auch vorgesehen sein, daß der Suchlauf bei einem Sender mit ausreichendem Pegel und einer anderen als der vor dem Start des Suchlaufs empfangenen Bereichskennung angehalten wird, wenn diese andere Bereichskennung während des Suchlaufs bereits einmal oder mehrmals bei einem Sender mit ausreichendem Pegel festgestellt wurde.

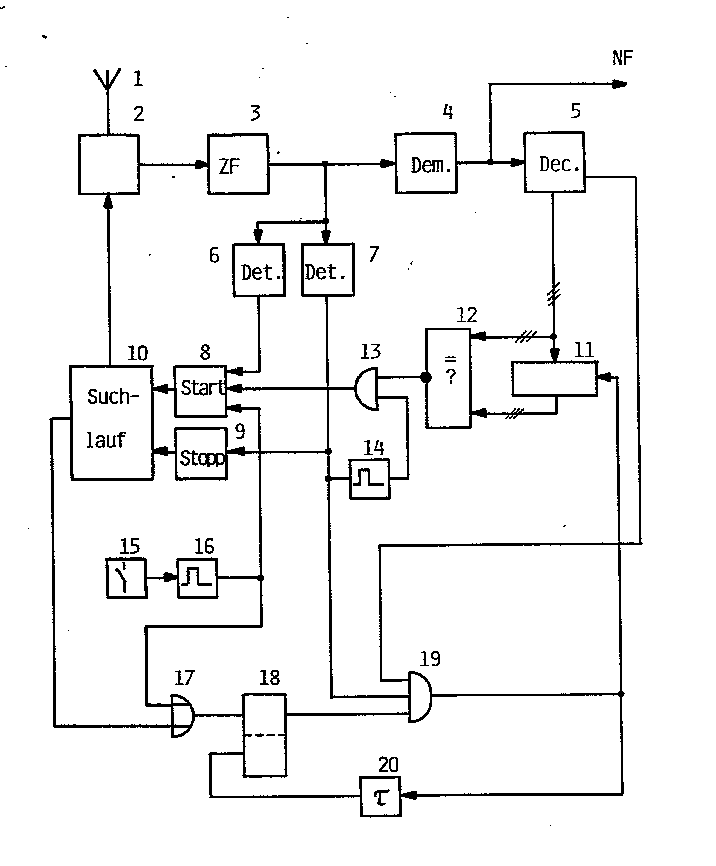

Ein Ausführungsbeispiel der Erfindung ist in der Zeichnung dargestellt und in der nachfolgenden Beschreibung näher erläutert.

Die Durchführung des erfindungsgemäßen Verfahrens ist mit verschiedenen Schaltungsanordnungen möglich, unter anderem durch die Verwendung eines entsprechend programmierten Mikroprozessors. Es sind jedoch auch einfache festverdrahtete Schaltungen möglich. Eine davon ist als Blockschaltbild in der Zeichnung dargestellt, wobei nur Teile eines Autoradios gezeigt und erläutert sind, soweit es zum Verständnis der Erfindung erforderlich ist.

Die zu empfangenen Hochfrequenzsignale werden über eine Antenne 1 einem Empfangsteil 2 zugeführt, das in an sich bekannter Weise Vor-und Mischstufen sowie einen Oszillator enthält. An das Empfangsteil 2 schließen sich ein ZF-Verstärker 3, ein Demodulator 4 und ein Decoder 5 an. Am Ausgang des Decoders 5 können die NF-Signale entnommen werden.

An den Ausgang des ZF-Verstärkers sind Pegeldetektoren 6, 7 angeschlossen. Der Pegeldetektor 6 gibt ein Signal ab, wenn der ZF-Pegel unter einen vorgegebenen Wert sinkt, während der Pegeldetektor 7 ein Signal abgibt, wenn der ZF-Pegel einen, vorzugsweise höheren Pegel, überschreitet.

Die Ausgänge der Pegeldetektoren 6, 7 sind mit einer Starteinrichtung 8 und einer Stoppeinrichtung 9 einer Suchlaufschaltung 10 verbunden, welche eine Abstimmspannung an das Empfangsteil 2 abgibt. Die Starteinrichtung 8 und die Stoppeinrichtung 9 können in einfacher Weise vom Setz-und vom Rücksetzeingang eines Flip-Flops gebildet sein, dessen Ausgangssignal die Suchlaufschaltung steuert.

Der Decoder 5 selektiert aus den demodulierten ZF-Signalen unter anderem die Bereichskennnungssignale und wandelt diese in digitale Bereichskennungssignale um. Letztere werden dem Eingang eines Registers 11 und einem Eingang eines Komparators 12 zugeführt. Der andere Eingang des Komparators ist mit dem Ausgang des Registers 11 verbunden.

Ein invertierender Ausgang des Komparators 12 ist an einen ersten Eingang einer UND-Schaltung 13 angeschlossen, deren Ausgang mit einem Eingang der Starteinrichtung 8 verbunden ist. Einem zweiten Eingang der UND-Schaltung 13 wird über einen monostabilen Multivibrator 14 das Ausgangssignal des Pegeldetektors 7 zugeführt.

Eine Taste 15 zum manuellen Start des Suchlaufs ist über einen Impulsformer 16 an einen weiteren Eingang der Starteinrichtung 8 und an einen Eingang eines Flip-Flops 17 angeschlossen, dessen einer Ausgang mit dem dritten Eingang der UND-Schaltung 13 verbunden ist.

Sinkt der Pegel eines empfangenen Senders unter einen vorgegebenen Wert, so wird vom Pegeldetektor 6 über die Starteinrichtung 8 der Suchlauf gestartet. Wird die Frequenz eines Senders erreicht, der einen ausreichenden Pegel zur Folge hat, so wird über den Pegeldetektor 7 und die Stoppeinrichtung 9 der Suchlauf angehalten.

Mit Hilfe des Komparators 12 wird die Bereichskennung des derzeit empfangenen Senders mit der Bereichskennung des zuvor empfangenen Senders, die im Register 11 gespeichert ist, verglichen. Sind die Bereichskennungen ungleich, so liegt am Ausgang des Komparators 12 eine logische 1 an. Diese wird jedoch nur weitergeleitet, wenn an dem anderen Eingang der UND-Schaltung 13 ebenfalls eine 1 anliegt. Dieses wird nach einem automatischen Start dadurch erreicht, daß für eine vorgegebene Zeit nach einem Stoppbefehl des Pegeldetektors 7 der monostabile Multivibrator 14 eine 1 abgibt.

Durch die Verknüpfung des von dem Stoppbefehl abgeleiteten Impulses mit dem Ausgangssignal des Komparators 12 wird sichergestellt, daß ein Startbefehl bei ungleichen Bereichskennungen nur gegeben wird, wenn ein Sender mit ausreichender Feldstärke empfangen wird.

Ein zweiter Ausgang der Suchlaufschaltung 10, der einen Impuls liefert, wenn beim Durchstimmen des Bereiches der gewünschte ARI-Sender nicht gefunden wurde, ist über die ODER-Schaltung 17 mit dem Setzeingang des Flip-Flops 18 verbunden, dessen Ausgang auf einen Eingang der UND-Schaltung 19 arbeitet. Die beiden anderen Eingänge der UND-Schaltung 19 sind mit dem Ausgang des Pegeldetektors 7 und mit einem zweiten Ausgang des Decoders 5 verbunden, der ein Signal liefert, wenn ARI erkannt wurde.

Der Ausgang der UND-Schaltung 19 ist mit dem Übernahmeeingang des Registers 11 und dem Eingang eines Verzögerungsgliedes 20 verbunden. Der Ausgang dieses Verzögerungsgliedes steuert den Rücksetzeingang des Flip-Flops 18. Nach einem erfolglosen Suchen nach einer vorgegebenen ARI-Kennung wird das Flip-Flop 18 gesetzt. Beim Auffinden eines ARI-Senders mit ausreichender Feldstärke und anderer Kennung liegen alle Eingänge der UND-Schaltung 19 auf logisch 1 und das Register 11 erhält den Befehl, die anliegende Bereichskennungs-Auswertung zu übernehmen. Um den Betrag der Übernahmezeit verzögert, gibt das Verzögerungsglied 20 ein Signal ab, welches das Flip-Flop 18 zurücksetzt.

Zum manuellen Start des Suchlaufs wird die Taste 15 betätigt, worauf der Impulsformer 16 einen Impuls an die Starteinrichtung 8 abgibt und über das ODER-Gatter 17 das Flip-Flop 18 derart setzt, daß an den zweiten Eingang der UND-Schaltung 19 eine 1 geführt wird. Damit wird der nächste ARI-Sender mit ausreichender Feldstärke vom Register 11 übernommen. Bevor der monostabile Multivibrator 14 das Signal abgibt, stellt der Komparator 12 Identität der ARI-Kennungen fest und schaltet den Ausgang auf logisch 0. Die Ausgangssignale des Komparators 12 können dann die Starteinrichtung 8 nicht erreichen, so daß der Suchlauf beim nächsten Sender mit ausreichendem Pegel unabhängig von dessen Bereichskennung stehenbleibt.

## Ansprüche

1. Verfahren zur Abstimmung eines Autoradios auf Verkehrsfunksender, bei welchem automatisch bei Unterschreiten eines vorgegebenen Pegels eines empfangenen Senders oder manuell ein Suchlauf gestartet wird, dadurch gekennzeichnet, daß der Suchlauf automatisch beim Empfang eines Senders mit ausreichendem Pegel angehalten wird, wenn der Sender mit ausreichendem Pegel eine gleiche Bereichskennung wie der zuvor empfangene Sender aussendet.

2. Verfahren nach Anspruch 1, dadurch gekennzeichnet, daß der Suchlauf bei einem beliebigen Sender mit ausreichendem Pegel vorläufig angehalten wird, daß ein Vergleich der Bereichskennungen des zuvor empfangenen Senders und des gerade empfangenen Senders erfolgt und daß der Suchlauf wieder gestartet wird, wenn das Ergebnis des Vergleichs Ungleichheit ist.

3. Verfahren nach Anspruch 1, dadurch gekennzeichnet,
daß nach einem manuellen Start der Suchlauf auch bei einem Sender mit ausreichendem Pegel, der eine andere Bereichskennung als der zuvor empfangene Sender aussendet, angehalten wird.

4. Verfahren nach Anspruch 1, dadurch gekennzeichnet,
daß eib der Bereichskennung des empfangenen Senders entsprechendes Signal gespeichert wird.

5. Verfahren nach Anspruch 1, dadurch gekennzeichnet,
daß der Suchlauf bei einem Sender mit ausreichendem Pegel und beliebiger Bereichskennung angehalten wird, wenn der Suchlauf mindestens einmal den gesamten Frequenzbereich durchlaufen hat.

6. Verfahren nach Anspruch 1, dadurch gekennzeichnet,
daß der Suchlauf bei einem Sender mit ausreichendem Pegel und einer anderen als der vor dem Start des Suchlaufs empfangenen Bereichskennung angehalten wird, wenn diese andere Bereichskennung während des Suchlaufs bereits einmal oder mehrmals bei einem Sender mit ausreichendem Pegel festgestellt wurde.

7. Schaltungsanordnung zur Durchführung des Verfahrens nach Anspruch 1, dadurch gekennzeichnet, daß in einem Autoradio ein Decoder (5) vorgesehen ist, der den empfangenen Signalen überlagerte Bereichskennungssignale in digitale Bereichskennungssignale umwandelt,
daß eine Suchlaufschaltung (10) eine Start-und eine StopEinrichtung (8, 9) umfaßt, welchen Signale von Pegeldetektoren zuführbar sind,
daß für die digitalen Bereichskennungssignale ein Speicher (11) vorgesehen ist, und
daß der Starteinrichtung (8) ferner das Ausgangssignal eines Komparators (12) zuführbar ist, welcher die gespeicherten digitalen Bereichskennungssignale mit den Ausgangssignalen des Decoders (5) vergleicht.

8. Schaltungsanordnung nach Anspruch 7, dadurch gekennzeichnet,
daß nach einem manuellen Start des Suchlaufs das Ausgangssignal des Komparators (12) der Starteinrichtung (8) nicht zuführbar ist.